# EUROPEAN PATENT SPECIFICATION

(11) **EP 2 642 501 B1**
(45) Date of publication and mention of the grant of the patent: **23.10.2019**
(21) Application number: 13172435.3
(22) Date of filing: 26.11.2008
(51) Int. Cl.: H01H 33/59, H01H 33/16, H01H 33/14

(54) **High voltage direct current breaker arrangement and method**
Hochspannungs-Gleichstrom-Leistungsschalteranordnung und Verfahren
Ensemble disjoncteur pour courant continu haute tension et procédé associé

(43) Date of publication of application: 25.09.2013
(62) Divisional of application: 08875377.7
(73) Proprietor: ABB Schweiz AG, 5400 Baden (CH)
(72) Inventor: Lescale, Victor, 791 42 Falun (SE)
(74) Representative: Ahrengart, Kenneth

(56) References cited:
- EP-A1- 0 758 137
- FR-A- 1 199 633
- JP-U- S54 153 368
- JP-U- S56 158 034

## Description

### Field of the invention

The invention relates generally to the field of electrical power transmission systems and in particular to means for interrupting or commutating a high voltage direct current. The invention also relates to a corresponding method.

### Background of the invention

High voltage direct current (HVDC) power systems comprise protection and control systems arranged to protect, monitor and control the functioning of devices forming part of the power system. The protection systems prevent, among other things, short-circuits, over-currents and over-voltages in e.g. power transmission lines of the HVDC system.

Protective relays are used throughout the HVDC system for providing such protection and control. The protective relays detect and isolate faults on transmission and distribution lines by opening and closing circuit breakers. It is not always necessary to perform a complete interruption; instead a commutation to an alternative path is performed. In essence the current in part(s) of the original current path will stop flowing, but it will not be interrupted, only redirected. To achieve this, a HVDC breaker is used.

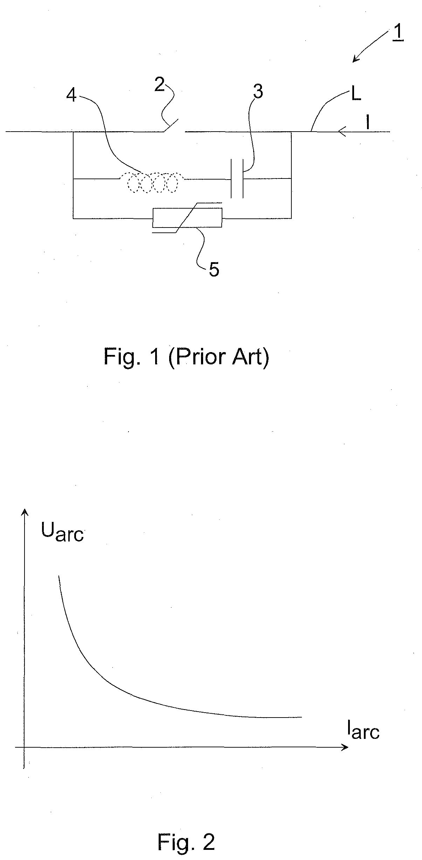

Figure 1 illustrates schematically a basic conventional direct current (DC) circuit breaker, also called DC breaker, which is arranged along a DC line L carrying a direct current I. The DC breaker 1 is designed so as to be able to break or commutate the direct current I. To this end the DC breaker 1 comprises an alternating current circuit breaker 2, denoted interrupter in the following, connected in parallel with a resonant LC branch 3, 4, i.e. a capacitor 3 connected in series with an inductor 4. A non-linear resistor 5 is connected in parallel with the LC branch 3, 4 for limiting the capacitor voltage when the direct current I flows through the capacitor instead of through the interrupter 2. The inductor 4 may, but needs not to, be a physical component; the leakage inductance in the circuit can often be enough.

In the following, a usual interrupting process is described. Upon interrupting or breaking the direct current I, a current is carried between the contacts of the interrupter 2 through an arc, and this arc current I_{arc} has to be extinguished. Figure 2 illustrates the arc characteristics of the arc current I_{arc} in the interrupter 2. For interrupter currents I_{arc} up to approximately 5 kA the arc voltage/current slope is negative, which causes a growing oscillation against the LC branch 3, 4. When the oscillating current has grown enough, i.e. so as to be equal to the direct current I, the arc current I_{arc} reaches a current zero crossing, whereupon the arc is extinguished and the total direct current goes through the capacitor 3. The voltage of the capacitor 3 then grows rapidly until it reaches the knee point of the non-linear resistor 5, e.g. a surge arrester, which is arranged to limit the voltage on the capacitor 3. The capacitor voltage constitutes a counter-voltage in the circuit causing the current I to decrease until it ceases.

The above-described conventional DC circuit breaker 1 functions properly for transmission line or HVDC circuit direct currents I up to approximately 4-5 kA. For higher currents, there are two main limiting factors in the interrupting process just described:
- The steady state current capability of the interrupter is today limited to approximately 5kA.
- The arc characteristic, as shown in Figure 2, is a curve, which beyond a certain arc current I_{arc} loses its negative slope and becomes flat, which makes it difficult to have an oscillation large enough to cause a zero crossing in the arc current I_{arc}. The corresponding direct current I at which the characteristic becomes flat is not an exact point but is somewhere around 4 to 5kA.

The documents JP S54 153368U, EP 0 758 137 A1 and JP S56 158034U disclose several arrangements of DC circuit breakers.

### Summary of the invention

It is an object of the invention to provide an improved DC circuit breaker arrangement able to handle much higher current levels than existing DC circuit breakers.

It is another object of the invention to provide a DC circuit breaker arrangement that can be implemented using existing components.

These objects, among others, are achieved by a DC circuit breaker arrangement and by a method as defined in the independent claims.

In accordance with the invention, a DC circuit breaker arrangement according to claim 1 is provided.

In particular, the DC circuit breaker arrangement comprises a first DC breaker, which in turn comprises a first interrupter connected to the line. The first DC breaker further comprises a first resonant LC branch and a first non-linear resistor connected in parallel with the first interrupter. The DC circuit breaker arrangement comprises further a second DC breaker, identical to the first DC breaker. The second DC breaker thus comprises a second interrupter and a second resonant LC branch and a second non-linear resistor connected in parallel with the second interrupter. The second DC breaker is connected in parallel with the first DC breaker on the line, where the parallel connection of first and second DC breaker is connected in series with the line. The direct current is divided between the first and second DC breakers. By introducing a division of the current into two or more branches, each branch carrying a part of the current, the steady state current in each interrupter is halved or lessened even more. Further, the current to be interrupted in each interrupter is also halved or lessened even more. By means of the invention, a DC circuit breaker arrangement is provided, able to handle direct currents up to 10 kA or even higher. The DC circuit breaker arrangement can be made by using conventional components that are readily available, rendering the DC circuit breaker arrangement cost-efficient and easy to manufacture. A DC circuit breaker arrangement is provided for use in applications wherein the nominal direct current or currents during overload conditions exceed the capacity of existing DC breakers.

In accordance with an embodiment of the invention, means are included for preserving the desired current division during an interruption process of the at least first and second DC breakers. A most reliable DC circuit breaker arrangement is thus provided, wherein there is no risk of the circuit breaker that interrupts its current first commutating the full current to the other circuit breaker.

In accordance with an example the means for preserving the current division during the interruption process comprises a two winding transformer connected to the first and second DC breakers. An arrangement can thus be implemented using conventional components, enabling a cost-efficient solution.

In accordance with the invention, a third DC breaker is provided connected in parallel with the first and second DC breakers on the transmission line or in the HVDC circuit. The current is thus divided between three branches and a DC circuit breaker arrangement able to handle even higher currents is thereby provided. Such circuit breaker arrangement is sufficient for all types of applications of a high voltage direct current (HVDC) network.

In accordance with still another example the means for enabling a preserved current distribution during the interruption process with three branches comprises three Z-connected (zig-zag-connected) transformers which are connected to the first, second and third DC breakers. Again, the arrangement can be implemented using conventional components, which enables a cost-efficient solution.

The invention is also related to a corresponding method, whereby advantages similar to the above are achieved.

Further embodiments and advantages thereof will become clear upon reading the following description.

### Brief description of the drawings

Figure 1 illustrates a basic conventional DC circuit breaker.
Figure 2 illustrates arc characteristics for an alternating current circuit breaker used as interrupter in a DC circuit breaker.
Figure 3 illustrates an example of a DC circuit breaker arrangement not in accordance with the present invention.
Figure 4 illustrates another example of a DC circuit breaker arrangement not in accordance with the present invention.
Figure 5 illustrates steps of a method in accordance with the present invention.

### Detailed description of embodiments

Figures 1 and 2 have already been described and the same reference numerals are used throughout the figures for denoting same or corresponding parts.

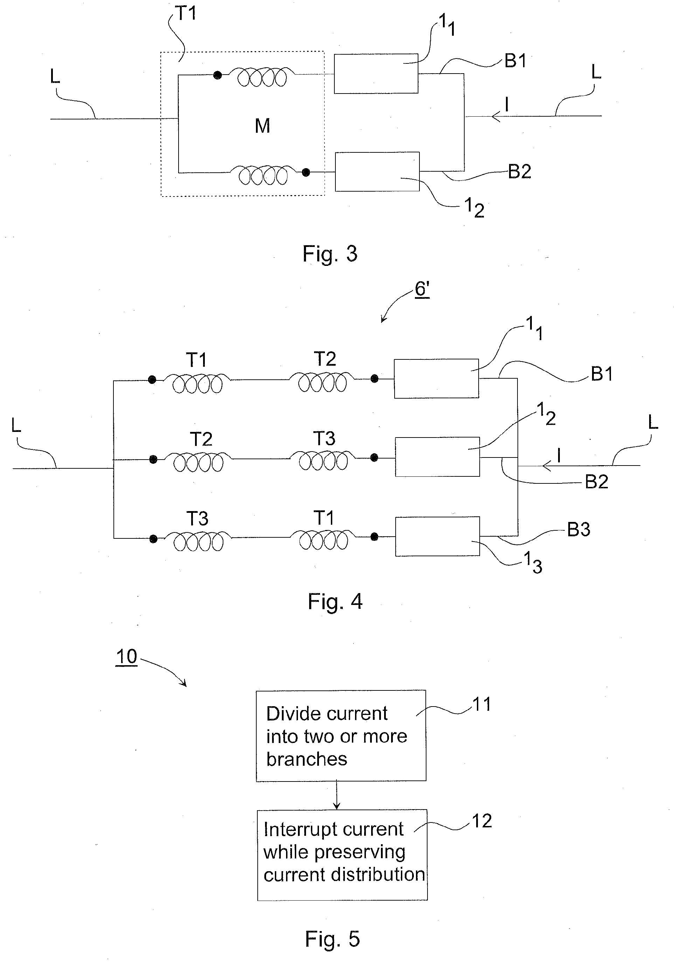

Figure 3 illustrates an exemplary arrangement not part of the invention. A DC circuit breaker arrangement, in the following denoted DC circuit breaker arrangement is arranged connected along, i.e. in series with, a line L carrying a dc current I. The line L can be a power transmission line or a connection line in a HVDC circuit.

In this arrangement the direct current I of the line L is divided into two branches B1 and B2. The two branches B1, B2 are identical, and each comprises a DC breaker 1₁, 1₂, which in turn comprises a respective first or second interrupter 2₁, 2₂ as described in connection with figure 1. Respective first or second LC branches 3₁, 4₁ and 3₂, 4₂ are connected in parallel with the respective first or second interrupter 2₁, 2₂. Further, first and second non-linear resistors 5₁ and 5₂ are connected in parallel with the respective first or second LC branches 3₁, 4₁; 3₂, 4₂. Each branch B1, B2 thus takes half the line current I.

To simply divide the direct current I into two paths would not solve the above-described problem of losing the negative current/voltage slope at high currents (see figure 2) and the entailing difficulties to effectuate a current interruption would remain. More specifically, if the direct current I were to be simply divided into the two branches B1, B2, then at the instant when one of the interrupters, either the first 2₁ or the second 2₂ interrupter, successfully breaks its current while the other is still in the process of extinguishing its arc, the full current would commutate into the other branch. The other branch would then not be able to interrupt the current. The same applies if the current were to be simply divided into more current paths.

Therefore, in order to preserve the desired current division during the interruption process, a two winding transformer T1 is used in accordance with the example. The magnetizing impedance of the two winding transformer T1 opposes an uneven current distribution that would occur in the above-described situation, when the one of the first and the second interrupters 2₁ and 2₂ has successfully interrupted its current.

The DC circuit breaker arrangement 6 in accordance with the example thus comprises two parallel-connected conventional DC breakers 1₁ and 1₂ connected to a two winding transformer T1, i.e. to a single-phase two-winding transformer comprising primary and secondary windings, or coils, wound around a single magnetic core. In particular, one of the DC breakers 1₁ and 1₂ is connected to the polarity end of one winding of the transformer T1, and the other DC breaker is connected to the non-polarity end of the other winding of the transformer T1. The winding polarities are shown in the figure by filled-in dots, in conventional manner. During steady state operation, the currents of the windings will cancel out the magnetic flux of each other in the core. Conventional components can thus be utilized, providing a cost-efficient DC circuit breaker arrangement.

When the direct current I is to be interrupted, the DC breakers 1₁, 1₂ work in conventional manner, as described in the introductory part of the present application. One of the DC breakers 1₁, 1₂ will succeed first in the current interruption process. The one first succeeding is denoted x and its current will flow through its associated capacitor 3ₓ. The voltage across the DC breaker 1ₓ will grow and this voltage will try to move the current in branch Bx to the other branch, which still has no counter-voltage. However, the magnetizing impedance of the transformer T1 prevents this from happening.

Figure 4 illustrates another arrangement. In the DC circuit breaker arrangement 6' the direct current I is divided into three branches B1, B2 and B3, each branch thus carrying a third of the direct current I during steady state operation. Each branch B1, B2, B3 comprises a respective DC breaker 1₁, 1₂, 1₃ with a layout as described earlier.

In order to preserve the current distribution during the current interruption process, three conventional transformers T1, T2, T3 are provided. The transformers T1, T2, T3 are connected in a zig-zag connection with the polarities as indicated in the figure 4. For the particular case with three branches, this transformer connection is also known as Z-connection, and could be achieved with a three-phase Z-connected transformer.

In particular, the non-polarity terminal of one coil on each transformer is connected to the non-polarity terminal of one coil in another transformer. Alternatively, the connection can be so that the polarity terminal of one coil on each transformer is connected to the polarity terminal of one coil of another transformer. During steady state operation, with opposing currents, the first and second coil winding's magnetic flux in each transformer will cancel each other out.

In a manner corresponding to the first example the mutual inductance of the transformers functions to preserve the current distribution during the interruption process.

Once all branches B1, B2, B3 have commutated their respective currents to their respective capacitors 3₁, 3₂, 3₃ or to their respective non-linear resistors 5₁, 5₂, 5₃, the leakage inductance of the transformer(s) will be added to the inductance of the total circuit, since all current derivatives will be in the same direction. However, the leakage inductance, also known as short circuit impedance, of a transformer is very low, several thousands times lower than the magnetizing inductance and can be neglected.

The principles of the examples may be applied in a corresponding manner to any number n of branches B1, B2 ..., Bn. The DC circuit breaker arrangement 6ⁿ⁻¹ can thus be designed and adapted for each specific application. However, the above-described DC circuit breaker arrangement 6' having three branches B1, B2, B3 is adequate for most applications that can be foreseen in the near future. It is noted that instead of using e.g. two parallel-connected DC breakers able to handle currents up to 5 kA, a number of more cost-efficient DC circuit breakers able to handle much lower currents, e.g. 500 A, can be used, applying the principles of the invention.

In the above description, a suitable number n of transformers is utilized in order to preserve the current division during an interruption process of the interrupters 2₁, 2₂, ..., 2ₙ. However, other means for preserving the current distribution between the different branches could be used instead.

A device comprising only reactors without relying on the above-described mutual inductance could, according to the invention, alternatively be used. However, considerations would have to be made regarding the fact that the very large inductance needed for preserving current distribution during interruption would remain in the circuit even after the interrupters in all branches have succeeded in commutating the current to their respective capacitors or non-linear resistors.

The invention also provides a method 10 for interrupting or commutating a direct current I on a transmission line L or HVDC circuit, as depicted in figure 5. The method 10 comprises a first step 11 of dividing the direct current I into three or more branches B1, B2, B3. A second step 12 comprises interrupting the direct current I by actuating DC breakers 1₁, 1₂, 1₃ arranged at each respective branch B1, B2, B3, while preserving, by means of a transformer arrangement, the current division during interruption of the direct current I. The DC breakers 1₁, 1₂, 1₃ are arranged as described earlier.

In summary, the present invention provides means for permitting the interruption of direct currents above 5 kA, most advantageously at 10 kA or even higher by combining conventional DC breakers having interrupters able to handle up to about 5 kA. The invention is thus advantageous for applications in which the current exceeds 5 kA, be it in nominal current or during overload conditions. By dividing the current into three or more branches, each one carrying less than half of the direct current I, the steady state current in each interrupter is more than halved. Further, the current to be interrupted (or to oscillate at) is more than halved. Further yet, an even current distribution is forced in steady state and transiently in an innovative manner.

## Claims

1. A DC circuit breaker arrangement (6') for interrupting a direct current (I) on a line (L), comprising:
- *n* DC circuit breakers (1₁, 1₂, 1₃) connected in parallel, where n > 2, which parallel connection of DC circuit breakers is connected in series with said line (L), said direct current (I) of said line (L) being divided between said *n* DC circuit breakers (1₁, 1₂, 1₃), where each DC circuit breaker (1₁, 1₂, 1₃) comprises an interrupter (2₁, 2₂, 2₃),
the DC circuit breaker arrangement being **characterized in that** each DC circuit breaker comprises a resonant LC branch (3₁, 3₂, 3₃, 4₁, 4₂, 4₃) and a non-linear resistor (5₁, 5₂, 5₃) connected in parallel with said interrupter (2₁, 2₂, 2₃), and **in that** the DC circuit breaker arrangement further comprises
- *n* reactors, each reactor being connected to one of the DC circuit breakers (1₁, 1₂, 1₃), for preserving said current division during current interruption when one of the interrupters breaks its current while the others are in the process of extinguishing their arcs.

2. The DC circuit breaker arrangement (6') as claimed in any of the preceding claims, wherein said line (L) is a high voltage DC transmission line or a part of an HVDC circuit.

3. A method for interrupting or commutating a direct current (I) on a transmission line (L) or in a HVDC circuit using a circuit breaker arrangement according to any previous claim, including the steps of:
- dividing said direct current (I) into *n* branches (B1, B2, B3), where n > 2,
- interrupting said direct current (I) by actuating DC circuit breakers (1₁, 1₂, 1₃) arranged at each branch (B1, B2, B3), while preserving, by means of n reactors, each reactor being connected to one of the DC circuit breakers (1₁, 1₂, 1₃), said current division during said current interruption when one of the interrupters breaks its current while the others are in the process of extinguishing their arcs.

## Patentansprüche

1. Gleichstromleistungsschalteranordnung (6') zum Unterbrechen eines Gleichstroms (I) in einer Leitung (L), die Folgendes umfasst:
- *n* Gleichstromleistungsschalter (1₁, 1₂, 1₃), die parallelgeschaltet sind, wobei n > 2, die Parallelschaltung von Gleichstromleistungsschaltern in Reihe mit der Leitung (L) geschaltet ist und der Gleichstrom (I) der Leitung (L) zwischen *n* Gleichstromleistungsschaltern (1₁, 1₂, 1₃) geteilt wird, wobei jeder Gleichstromleistungsschalter (1₁, 1₂, 1₃) einen Unterbrecher (2₁, 2₂, 2₃) umfasst, wobei
die Gleichstromleistungsschalteranordnung **dadurch gekennzeichnet ist, dass** jeder Gleichstromleistungsschalter einen LC-Resonanzzweig (3₁, 3₂, 3₃, 4₁, 4₂, 4₃) und einen nichtlinearen Widerstand (5₁, 5₂, 5₃), der mit dem Unterbrecher (2₁, 2₂, 2₃) parallelgeschaltet ist, umfasst, und dass die Gleichstromleistungsschalteranordnung ferner Folgendes umfasst:
- *n* Drosselspulen, wobei jede Drosselspule mit einem der Gleichstromleistungsschalter (1₁, 1₂, 1₃) verbunden ist, um die Stromteilung während einer Stromunterbrechung zu erhalten, wenn einer der Unterbrecher seinen Strom unterbricht, während die Weiteren im Vorgang des Löschens ihrer Lichtbögen sind.

2. Gleichstromleistungsschalteranordnung (6') nach einem der vorhergehenden Ansprüche, wobei die Leitung (L) eine Hochspannungsgleichstromübertragungsleitung oder ein Teil einer HVDC-Schaltung ist.

3. Verfahren zum Unterbrechen oder Kommutieren eines Gleichstroms (I) in einer Übertragungsleitung (L) oder in einer HVDC-Schaltung unter Verwendung einer Gleichstromleistungsschalteranordnung nach einem vorhergehenden Anspruch, das die folgenden Schritte umfasst:
- Teilen des Gleichstroms (I) in n Zweige (B1, B2, B3), wobei n > 2,
- Unterbrechen des Gleichstroms (I) durch Betätigen von Gleichstromleistungsschaltern (1₁, 1₂, 1₃), die in jedem Zweig (B1, B2, B3) angeordnet sind, während die Stromteilung mittels n Drosselspulen, wobei jede Drosselspule mit einem der Gleichstromleistungsschalter (1₁, 1₂, 1₃) verbunden ist, während der Stromunterbrechung erhalten wird, wenn einer der Unterbrecher seinen Strom unterbricht, während die Weiteren im Vorgang des Löschens ihrer Lichtbögen sind.

## Revendications

1. Agencement (6') de disjoncteurs pour courant continu destiné à interrompre un courant continu (I) sur une ligne (L), comportant :
- *n* disjoncteurs (1₁, 1₂, 1₃) pour courant continu raccordés en parallèle, où n > 2, ledit raccordement en parallèle de disjoncteurs pour courant continu étant raccordé en série avec ladite ligne (L), ledit courant continu (I) de ladite ligne (L) étant divisé entre lesdits *n* disjoncteurs (1₁, 1₂, 1₃) pour courant continu, chaque disjoncteur (1₁, 1₂, 1₃) pour courant continu comportant un interrupteur (2₁, 2₂, 2₃),
l'agencement de disjoncteurs pour courant continu étant **caractérisé en ce que** chaque disjoncteur pour courant continu comporte une branche LC résonante (3₁, 3₂, 3₃, 4₁, 4₂, 4₃) et une résistance non linéaire (5₁, 5₂, 5₃) raccordées en parallèle avec ledit interrupteur (2₁, 2₂, 2₃), et **en ce que** l'agencement de disjoncteurs pour courant continu comporte en outre
- n réactances, chaque réactance étant raccordée à un des disjoncteurs (1₁, 1₂, 1₃) pour courant continu, pour préserver ladite division de courant pendant l'interruption du courant lorsqu'un des interrupteurs coupe son courant tandis que les autres sont en cours d'extinction de leurs arcs.

2. Agencement (6') de disjoncteurs pour courant continu selon l'une quelconque des revendications précédentes, ladite ligne (L) étant une ligne de transmission de courant continu à haute tension ou une partie d'un circuit HVDC.

3. Procédé d'interruption ou de commutation d'un courant continu (I) sur une ligne (L) de transmission ou dans un circuit HVDC à l'aide d'un agencement de disjoncteurs selon l'une quelconque des revendications précédentes, comprenant les étapes consistant à :
- diviser ledit courant continu (I) en *n* branches (B1, B2, B3), où n > 2,
- interrompre ledit courant continu (I) en actionnant des disjoncteurs (1₁, 1₂, 1₃) pour courant continu agencés au niveau de chaque branche (B1, B2, B3), tout en préservant, au moyen de *n* réactances, chaque réactance étant raccordée à un des disjoncteurs (1₁, 1₂, 1₃) pour courant continu, ladite division de courant pendant ladite interruption de courant lorsqu'un des interrupteurs coupe son courant tandis que les autres sont en cours d'extinction de leurs arcs.
